# EUROPEAN PATENT APPLICATION

(11) **EP 3 839 542 A1**
(43) Date of publication of application: **23.06.2021**
(21) Application number: 19216384.8
(22) Date of filing: 16.12.2019
(51) Int. Cl.: G01R 33/3873

(54) **OPTIMIZED ORIENTATION OF SHIM ELEMENTS IN AN MRI SYSTEM**

(71) Applicant: Koninklijke Philips N.V., 5656 AG Eindhoven (NL)
(72) Inventor: PRICOP, Valentin, 5656 AE Eindhoven (NL); MULDER, Gerardus Bernardus Jozef, 5656 AE Eindhoven (NL)
(74) Representative: Philips Intellectual Property & Standards

(57) **Abstract**

The present invention concerns a main magnet assembly (2) for a magnetic resonance examination system (1), comprising at least one shim element (5) to correct for spatial inhomogeneities of a static magnetic field of the main magnet assembly (2), wherein the shim element (5) is orientated depending on their radial, azimuthal and axial position in a coordinate frame of the main magnet assembly (2). The invention also concerns a shim rail (4) with a plurality of shim pockets (6), a magnetic resonance examination system (1), a method for correcting for spatial inhomogeneities of the static magnetic field of the main magnet assembly (2) of a magnetic resonance examination system (1) and a software package for correcting for spatial inhomogeneities of the static magnetic field of the main magnet assembly (2) of a magnetic resonance (MR) examination system (1).

## Description

### FIELD OF THE INVENTION

The invention relates to the field of a magnetic resonance examination system, and in particular to a main magnet assembly for a magnetic resonance examination system comprising at least one shim element to correct for spatial inhomogeneities of a static magnetic field of the main magnet assembly. The invention relates also to a shim rail with a plurality of shim pockets, a magnetic resonance examination system and a method for correcting for spatial inhomogeneities of the static magnetic field of the main magnet assembly. Further the invention relates to a software package for correcting for spatial inhomogeneities of the static magnetic field of the main magnet assembly.

### BACKGROUND OF THE INVENTION

In nuclear magnetic resonance (NMR) and magnetic resonance imaging (MRI), shimming is used prior to the operation of the magnet to eliminate inhomogeneities in its static magnetic field. Initially, the magnetic field inside an NMR spectrometer or MRI scanner is far from homogeneous compared with an "ideal" field of the device. This is a result of production tolerances and of the environment of the scanner. Iron constructions in walls and floor of the examination room become magnetized and disturb the field of the scanner. The probe and the sample or the patient become slightly magnetized when brought into the strong magnetic field and create additional inhomogeneous fields. The process of correcting for these inhomogeneities is called shimming the magnet, shimming the probe or shimming the sample, depending on the assumed source of the remaining inhomogeneity. Field homogeneity of the order of 1 ppm over a volume of several liters is needed in an MRI scanner. High-resolution NMR spectroscopy demands field homogeneity better than 1 ppb within a volume of a few milliliters.

In general, there are two types of shimming: active shimming and passive shimming. Active shimming uses coils with adjustable current. Passive shimming involves pieces of steel with suitable magnetic properties, also called shim irons. The shim irons are placed near the permanent or superconducting magnet. They become magnetized and produce their own magnetic field. In both cases, the additional magnetic fields from the coils or shim irons, respectively, add to the overall magnetic field of the superconducting magnet in such a way as to increase the homogeneity of the total field.

Typically, an MRI scanner comprises a field-generating unit (both B0+gradients), which has openings along the longitudinal axis into which shim rails are inserted. These shim rails have various pockets into which shim irons are placed. In present MRI scanners, shim irons are typically placed at locations where the gradient field is close to maximum. Further, in such a configuration, the shim irons are mechanically connected to the gradient-generating unit, which is prone to vibration, rather than to the B0-generating unit (the inner hull of the cryostat), which is rather static. Therefore, the recent deployment of such MRI scanners leads to an aggravation of a problem long known, i.e. the heating of the shim irons and hence the thermal drift of the shimming.

This means that though by careful passive shimming very good static homogeneity of the main magnetic field may be achieved, there is a disadvantage of this technique in that the magnetization of the shim material is temperature sensitive, and when the bore heats (as it commonly does with gradient-intensive sequences), field shifts may occur. Heating of the shim plates is caused, among other phenomena, by eddy currents. A time variant magnetic flux (the gradient field) induces currents in the shim plates which heat the shim plates. Hence, changes in temperature will cause the magnetic distribution created by the passive shims to change, with potentially detrimental effects on image quality and geometric accuracy. The implementation of passive shim elements must therefore proceed only with the awareness that their proper functioning depends on stable temperature conditions.

Various attempts were therefore presented in patent literature to keep the temperature of the shim irons constant for the time of an imaging scan or imaging sequence, e.g. pre-heating them locally, special cooling directly for the shim irons, or by regulating the cooling on the outflow rather than the inflow temperature. Alternatively, materials or mixture of materials may be used, in which the negative thermal coefficient of the saturation of the magnetization of the iron is counteracted.

From US 7,427,908 B1 a magnetic shimming configuration for a high-field magnet having optimized turn geometry and electrical circuitry is known. The configuration accomplishes this by combining the corrective functionalities of the standard X and ZX shims into two single, simplified electrical circuits and conductors, optimized for field strength as a function of turn location. The standard Y and ZY shims were also replaced with two single, simplified circuits and conductor that is corrective of the Y and ZY fields. The new configuration also eliminates the need of additional "second, outboard turns" of the traditional X, ZX, Y, and ZY shims, located further away from the mid-plane.

### SUMMARY OF THE INVENTION

It is an object of the invention to provide an easy and effective way for shimming a MR system with shim elements with substantially reduced heating caused by eddy currents induced by gradient fields.

According to the invention, this object is addressed by the subject matter of the independent claims. Preferred embodiments of the invention are described in the sub claims.

Therefore, according to the invention, a main magnet assembly for a magnetic resonance examination system is provided, comprising at least one shim element to correct for spatial inhomogeneities of a static magnetic field of the main magnet assembly, wherein the shim element is orientated depending on their radial, azimuthal and axial position in a coordinate frame of the main magnet assembly.

In the traditional shim system consisting of iron plates located in the intermediate space between the active windings and shielding windings of the gradient coil, the heating of the shim elements is problematic because it can lead to image quality problems of the MRI system. This invention reduces the heating by re-orienting the shim elements in a non-standard direction, depending on the region where they are located.

The essence of the invention is to orient all shim elements to an optimized direction, depending on the region where they are located, such that the heat generating eddy-currents induced in the shim elements are minimized. This reduces heating effects, which eventually improves the image quality of the MRI system. This is especially relevant for high end MRI systems with high gradient performance.

According to a preferred embodiment the main magnet assembly comprises a plurality of shim elements, wherein different shim elements are arranged with different orientations at different positions in the coordinate frame of the main magnet assembly.

According to another preferred embodiment the coordinate frame of the main magnet assembly is a circumferential-axial coordinate frame, wherein the shim elements are oriented with their surface normal along the *r* axis, oriented with their surface normal along the *φ* axis, or oriented with their surface normal along the *z* axis, depending on their radial, azimuthal and axial position in the circumferential-axial plane of the main magnet assembly.

According to a preferred embodiment the shim elements are oriented according to the circumferential-axial plane, wherein each point of the circumferential-axial plane can be defined by a position along said *z* axis and its azimuthal position in degrees, wherein the z axis goes from -*z* to *z*, wherein in an area around a mid-plane in the axial direction at *z*=*0* and between an azimuthal position of 0 degrees to 360 degrees the shim elements are orientated with their surface normal along the *r* axis, in an area of the *z* axis from essentially -*z* to the area around the mid-plane in the axial direction and in an area of the *z* axis from the area around the mid-plane in the axial direction to essentially *z* the shim elements are orientated with their surface normal along the *φ* axis, wherein at cyclical intervals in an area of the *z* axis of essentially -*z* and *z* the shim elements are orientated with their surface normal along the *z* axis.

According to another preferred embodiment at the cyclical intervals in an area approximately in the middle of the area between -*z* to the area around the mid-plane in the axial direction and in an area of the *z* axis from the area around the mid-plane in the axial direction to essentially *z* the shim elements are orientated with their surface normal along the *z* axis.

According to a preferred embodiment the cyclical intervals start at an azimuthal angle of substantially 22,5 degrees and repeat every 45 degrees.

According to another preferred embodiment the shim elements are made of iron-silicon alloy.

According to a preferred embodiment the shim elements having a rectangular shape and a thickness of up to 1 mm

In another aspect of the invention, the object is achieved by a shim rail with a plurality of shim pockets, wherein at least one pocket comprises a shim element orientated depending on their radial, azimuthal and axial position in the coordinate frame of the main magnet assembly according to any of the preceding claims.

According to a preferred embodiment the sizes of the shim elements are adapted to the three orientations of the shim elements, wherein the sizes of the shim elements are given by the sizes of the shim pockets.

In another aspect of the invention, the object is achieved by a magnetic resonance examination system with a bore for accommodating a subject to examined and a main magnet assembly surrounding the bore, wherein the main magnet assembly comprises a plurality of openings which run parallel to the longitudinal axis of the bore and wherein at least one of the plurality of openings comprises a shim rail as previously described.

In a further aspect of the invention, the object is achieved by a method for correcting for spatial inhomogeneities of the static magnetic field of the main magnet assembly of a magnetic resonance examination system as previously described comprising the steps of:
- acquiring an inhomogeneity map indicating magnetic field intensity differences over a volume in the main magnet assembly;
- calculating a number of shim elements based on the inhomogeneity map to correct for spatial inhomogeneities of the static magnetic field of the main magnet assembly which are to be installed in at least one shim pocket of a shim rail;
- calculating the corresponding position of the shim pocket in the *φz* plane of the main magnet assembly;
- creating an optimized shim orientation map for the position of the shim pocket;
- extracting from the optimized shim orientation map the optimal orientation of the shim elements at the position of the shim pocket;
- calculating the number of shim elements to be installed in the shim pocket based on the orientation of the shim elements.

In a still further aspect of the present invention, the object is achieved by a software package for correcting for spatial inhomogeneities of the static magnetic field of the main magnet assembly of a magnetic resonance examination system, whereby the software package contains instructions, that when executed on a processor, perform the method steps as previously described. The software package, or more precisely the instructions, can be stored on a non-transitory computer-readable medium, for example.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a magnetic resonance examination system with a main magnet assembly according to a preferred embodiment of the invention;
Fig. 2 schematically depicts the definition of the coordinate system and of the axes of a main magnet assembly according to an embodiment of the invention;
Fig. 3 schematically depicts the three shim orientations: H orientation (left), V orientation (center) and U orientation (right) according to an embodiment of the invention;
Fig. 4 shows an optimized shim orientation map for H orientation, V orientation and U orientation according to an embodiment of the invention;
Fig. 5 shows a flowchart which illustrates a method for correcting for spatial inhomogeneities of the static magnetic field of a main magnet assembly of a magnetic resonance examination system in accordance with an embodiment of the invention.

### DETAILED DESCRIPTION OF EMBODIMENTS

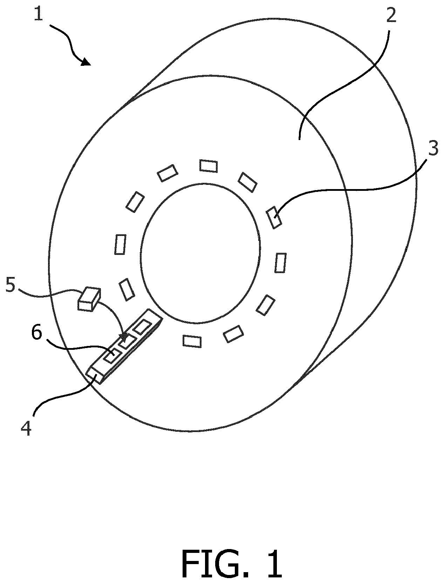

Fig. 1 schematically depicts a magnetic resonance examination system with a main magnet assembly 2 according to a preferred embodiment of the invention. The shim system consists of many iron-alloy plates, at distributed locations, needed to make the field of the MRI magnet more homogeneous. The shim system is integrated in the shielded gradient coil, physically located in the space between active gradient windings and shielding windings. The shim plates or shim elements 5 which are made e.g. of iron-silicon alloy, having a rectangular shape, and a thickness of up to 1 mm. The main magnet assembly 2 has openings 3 along the longitudinal axis, into which shim rails 4 are inserted. These shim rails 4 have various pockets 6 into which the shim elements 5 are placed. The essence of the invention is to orient all shim elements 5 to an optimized direction, depending on the region where they are located, such that the heat generating eddy-currents induced in the shim elements 5 are minimized. This reduces heating effects, which improves the image quality of the magnetic resonance examination system. This is especially relevant for high end MRI systems with high gradient performance.

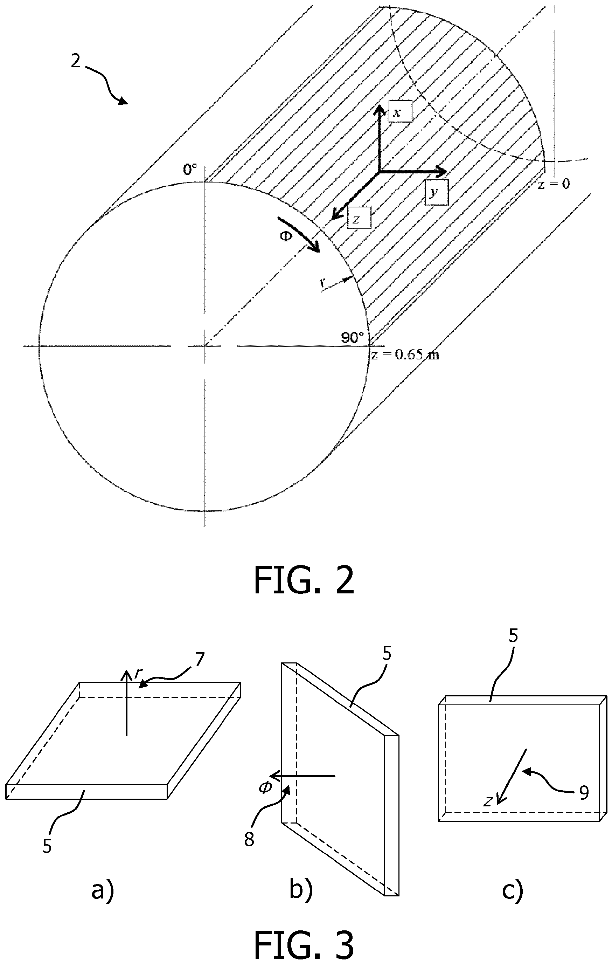

Fig. 2 depicts the definition of the coordinate system and of the axes of a main magnet assembly 2 according to an embodiment of the invention. The hashed region in Fig. 2 represents a patch in the *φz* plane 11 at radius *r.* In Fig. 2 the *z* axis goes from *z* = *0 m* to *z* = *0.65 m*, and from *φ* = *0*° to *φ* = *90*°. The corresponding main magnet assembly 2 can have e.g. a total length of 1.3 m going from *-z*=*-0.65 m* to *z*=*0.65 m.* In an embodiment of the invention three possible orientations 7, 8, 9 of the shim elements 5 can be foreseen: Shim elements 5 with their surface normal oriented along the *r* axis 7, further called the H orientation, shim elements 5 with their surface normal oriented along the *φ* axis 8, further called the V orientation and shim elements 5 with their surface normal oriented along the *z* axis 9, further called the U orientation. Considering the fact that the shape of the shim pocket 6 is not cubic, shim elements 5 of size adapted to the three orientations may be provided, wherein the three shim sizes are given by the size of the shim pocket 6.

Fig. 3 depicts the three shim element orientations in the coordinate system according to an embodiment of the invention. Fig. 3 a) shows the H orientation, wherein the surface normal of the shim element 5 is oriented along the *r* axis 7. Fig. 3 b) shows the V orientation, wherein the surface normal of the shim element 5 is oriented along the *φ* axis 8. Fig. 3 c) shows the U orientation, wherein the surface normal of the shim element 5 is oriented along the *z* axis 9.

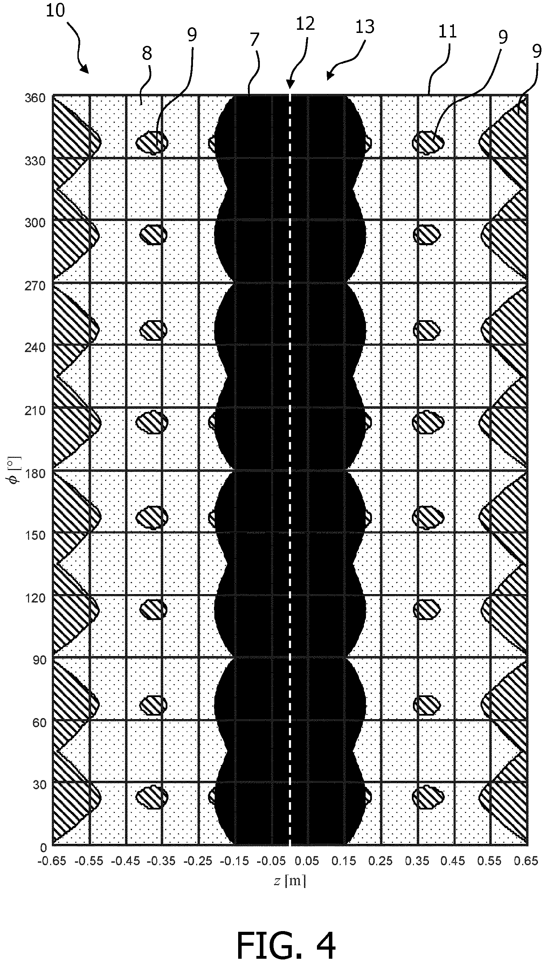

Fig. 4 shows an optimized shim orientation map for H orientation 7, V orientation 8 and U orientation 9 according to an embodiment of the invention. The map in Fig. 4 shows the circumferential-axial plane (*φz* plane) 11 and shows which orientation to use for the shim elements 5 positioned at a certain *φz* coordinate.

In general, the main magnet assembly 2 comprises a plurality of shim elements 5, wherein different shim elements 5 are arranged with different orientations 7, 8, 9 at different positions in the coordinate frame of the main magnet assembly 2.

In an embodiment of the invention the coordinate frame of the main magnet assembly 2 is a circumferential-axial coordinate frame, wherein the shim elements 5 are oriented with their surface normal along the *r* axis 7, along with their surface normal along the *φ* axis 8, or with their surface normal along the *z* axis 9 depending on their radial, azimuthal and axial position in a circumferential-axial plane 11 of the main magnet assembly 2.

The circumferential-axial plane 11 in Fig. 4 shows an example for an optimized shim orientation map for a main magnet assembly 2. Each point of the circumferential-axial plane 11 can be defined by a position along the *z* axis and its azimuthal position *φ* in degrees, wherein the *z* axis goes from -*z* to *z*.

In an area around a mid-plane in the axial direction 12 at *z*=0 and between an azimuthal position *φ* of 0 degrees to 360 degrees the shim elements 5 are orientated with their surface normal along the *r* axis 7. In the example shown in Fig. 4 the main magnet assembly 2 has a total length of 1.30 m, wherein the *z* axis goes from *-z*=-0.65 m to *z*=0.65 m. The mid-plane in the axial direction 12 shown in Fig. 4 goes from essentially *-z*=-0.15 m to *z*=0.15 m. In this area the shim elements 5 are orientated with their surface normal along the *r* axis 7. In an area of the *z* axis of essentially -0.50 m to -0.15 m and 0.15 m to 0.55 m the shim elements 5 are orientated with their surface normal along the *φ* axis 8. In an area of the *z* axis of essentially -0.65 m to -0.55 m and 0.55 m to 0.65 m the shim elements 5 are orientated with their surface normal along the *z* axis 9.

In an embodiment of the invention, which is also shown in Fig. 4, in an area of the z axis of essentially -0.65 m to -0.55 m and 0.55 m to 0.65 m and at an angle substantially of 0°, 45°, 90°, 135°, 180°, 225°, 270°, 315°, 360° the shim elements 5 are orientated with their surface normal along the *φ* axis 8. Also shown in Fig. 4 and according to another embodiment of the invention in the area of the z axis of essentially -0.45 m to -0.32 m and at an angle substantially of 22,5°, 67.5°, 112.5°, 157.5°, 202.5°, 247.5°, 252.5°, 297.5°, 342.5° the shim elements 5 are orientated with their surface normal along the *φ* axis 8.

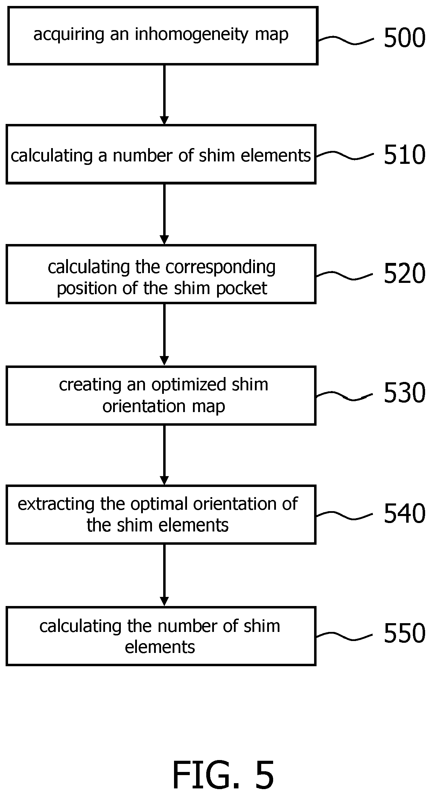

Fig. 5 shows a flowchart which illustrates a method for correcting for spatial inhomogeneities of the static magnetic field of a main magnet assembly 2 of a magnetic resonance examination system in accordance with an embodiment of the invention.

During the shimming process a software package calculates an amount of shim elements 5 which are to be installed in shim pockets 6 of shim rails 4. Currently, the shimming software package specifies only the number of shim elements 5 to add or to remove from a shim pocket 6. The shimming software package needs to be updated to calculate the position of the shim pocket 6 in the *φz* plane. The software extracts from an optimized shim orientation map the orientation of the shim elements 5. The software then needs to calculate the number of shim elements 5 to be installed in the shim pocket 6 based on the orientation of the shim elements 5.

Therefore, according to the invention, a method for correcting for spatial inhomogeneities of the static magnetic field of a main magnet assembly 2 of a magnetic resonance examination system is also provided.

In an embodiment of the invention the method starts with step 500, in which an inhomogeneity map, indicating magnetic field intensity differences over a volume in the main magnet assembly 2, is acquired.

In step 510, a number of shim elements 5 is calculated based on the inhomogeneity map to correct for spatial inhomogeneities of the static magnetic field of the main magnet assembly which are to be installed in at least one shim pocket 6 of a shim rail 4.

In step 520, the corresponding position of the shim pocket 6 in the *φz* plane of the main magnet assembly 2 is calculated.

In step 530, an optimized shim orientation map 10 for the position of the shim pocket 6 is created.

In step 540, the optimal orientation of the shim elements 5 at the position of the shim pocket 6 is extracted from the optimized shim orientation map 10.

In step 550, the number of shim elements 5 to be installed in the shim pocket 6 based on the orientation of the shim elements 5 is calculated. In particular, a software package for correcting for spatial inhomogeneities of the static magnetic field of the main magnet assembly 2 of a magnetic resonance (MR) examination system, may be provided whereby the software package contains instructions, that when executed on a processor, perform the method steps as described above.

In an embodiment of the invention the shimming software package assumes that the shims are placed at the center of the shim pocket 6. For the V orientation 8 and U orientation 9 the shim elements 5 can be positioned also to either size of the pocket. Therefore, the person performing the shimming operation can position the shim elements 5 in the center of the shim pocket 6 and position e.g. filler plates toward the outside of the shim pocket 6.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| magnetic resonance examination system | 1 |
| main magnet assembly | 2 |
| openings | 3 |
| shim rails | 4 |
| shim element | 5 |
| shim pocket | 6 |
| H orientation, surface normal oriented along the *r* axis | 7 |
| V orientation, surface normal oriented along the *φ* axis | 8 |
| U orientation, surface normal oriented along the z axis | 9 |
| shim element orientation map | 10 |
| *φz* plane | 11 |
| mid-plane in the axial direction | 12 |
| area around the mid-plane in the axial direction | 13 |
| *r* axis | *r* |
| *z* axis | *z* |
| *φ* axis | *φ* |

## Claims

1. A main magnet assembly (2) for a magnetic resonance examination system (1),
comprising at least one shim element (5) to correct for spatial inhomogeneities of a static magnetic field of the main magnet assembly (2), wherein the shim element (5) is orientated depending on their radial, azimuthal and axial position in a coordinate frame of the main magnet assembly (2).

2. A main magnet assembly according to claim 1, wherein the main magnet assembly (2) comprises a plurality of shim elements (5), wherein different shim elements (5) are arranged with different orientations (7, 8, 9) at different positions in the coordinate frame of the main magnet assembly (2).

3. A main magnet assembly according to claim 2, wherein the coordinate frame of the main magnet assembly (2) is a circumferential-axial coordinate frame, wherein the shim elements (5) are oriented with their surface normal along the *r* axis (7), oriented with their surface normal along the *φ* axis (8), or oriented with their surface normal along the *z* axis (9) depending on their radial, azimuthal and axial position in a circumferential-axial plane (11) of the main magnet assembly (2).

4. A main magnet assembly according to claim 3, wherein the shim elements (5) are oriented according to the circumferential-axial plane (11), wherein each point of the circumferential-axial plane (11) can be defined by a position along said *z* axis (*z*) and its azimuthal position (*φ)* in degrees, wherein the z axis (*z*) goes from *-z* to *z*, wherein
in an area around a mid-plane in the axial direction (12) at *z*=*0* and between an azimuthal position (*φ*) of 0 degrees to 360 degrees the shim elements (5) are orientated with their surface normal along the *r* axis (7),
in an area of the *z* axis (*z*) from essentially -*z* to the area around the mid-plane in the axial direction and in an area of the *z* axis (*z*) from the area around the mid-plane in the axial direction to essentially *z* the shim elements (5) are orientated with their surface normal along the *φ* axis (8), wherein
at cyclical intervals in an area of the *z* axis (*z*) of essentially -*z* and *z* the shim elements (5) are orientated with their surface normal along the *z* axis (9).

5. A main magnet assembly according to claim 4, wherein at the cyclical intervals in an area approximately in the middle of the area between -*z* to the area around the mid-plane in the axial direction (12) and in an area of the *z* axis from the area around the mid-plane in the axial direction (12) to essentially *z* the shim elements (5) are orientated with their surface normal along the *z* axis (9).

6. A main magnet assembly according to claim 4 or 5, wherein the cyclical intervals start at an azimuthal angle of substantially 22,5 degrees and repeat every 45 degrees.

7. A main magnet assembly according to any of the preceding claims wherein the shim elements (5) are made of iron-silicon alloy.

8. A main magnet assembly according to any of the preceding claims wherein the shim elements (5) having a rectangular shape and a thickness of up to 1 mm

9. A shim rail (4) with a plurality of shim pockets (6), wherein at least one pocket (6) comprises a shim element (5) orientated depending on their radial, azimuthal and axial position in the coordinate frame of the main magnet assembly (2) according to any of the preceding claims.

10. A shim rail (4) according to claim 9, wherein the sizes of the shim elements (5) are adapted to the three orientations of the shim elements (5), wherein the sizes of the shim elements (5) are given by the sizes of the shim pockets (4).

11. A magnetic resonance examination system (1) with a bore for accommodating a subject to examined and a main magnet assembly (2) surrounding the bore, wherein the main magnet assembly (2) comprises a plurality of openings (3) which run parallel to the longitudinal axis of the bore and wherein at least one of the plurality of openings (3) comprises a shim rail (4) according to claims 9 to 10.

12. A method for correcting for spatial inhomogeneities of the static magnetic field of the main magnet assembly (2) of a magnetic resonance examination system (1) according to any one of claims 1 to 8, comprising a shim rail (4) according to any one of claims 9 to 10 comprising the steps of:
- acquiring an inhomogeneity map indicating magnetic field intensity differences over a volume in the main magnet assembly (2);
- calculating a number of shim elements (5) based on the inhomogeneity map to correct for spatial inhomogeneities of the static magnetic field of the main magnet assembly (2) which are to be installed in at least one shim pocket (6) of a shim rail (4);
- calculating the corresponding position of the shim pocket (6) in the *φz* plane of the main magnet assembly (2);
- creating an optimized shim orientation map (10) for the position of the shim pocket (6);
- extracting from the optimized shim orientation map (10) the optimal orientation of the shim elements (5) at the position of the shim pocket (6);
- calculating the number of shim elements (5) to be installed in the shim pocket (6) based on the orientation of the shim elements (5).

13. A software package for correcting for spatial inhomogeneities of the static magnetic field of the main magnet assembly (2) of a magnetic resonance (MR) examination system (1), whereby the software package contains instructions, that when executed on a processor, perform the method steps according to claim 12.
